# EUROPÄISCHE PATENTANMELDUNG

(11) **EP 0 994 501 A2**
(43) Veröffentlichungstag der Anmeldung: **19.04.2000**
(21) Anmeldenummer: 99119558.7
(22) Anmeldetag: 01.10.1999
(51) Int. Cl.: H01L 21/00

(54) **Vorrichtung zum Lagern und Kommissionieren von Gegenständen, insbesondere von scheibenartigen Gegenständen wie Wafern oder dergleichen**

(30) Priorität: 15.10.1998 DE 19847659
(71) Anmelder: Infineon Technologies AG, 81541 München (DE)
(72) Erfinder: Roithner, Klaus, 01458 Ottendorf-Okrilla (DE); Missale, Reiner, 93155 Hemau (DE)
(74) Vertreter: Zedlitz, Peter

(57) **Zusammenfassung**

Es wird eine Vorrichtung zum Lagern und Kommissionieren von Gegenständen, insbesondere von scheibenartigen Gegenständen wie Wafern oder dergleichen, beschrieben. Um zu erreichen, daß einzelne der gelagerten Gegenstände auf einfache und kostengünstige Weise zu logischen Einheiten zusammengestellt werden können, die dann entsprechend weiter bearbeitet oder weiter transportiert werden, weist die Vorrichtung (10) erfindungsgemäß ein Lagersystem (11) zur Aufnahme einer Anzahl von Gegenständen (20) auf, wobei das Lagersystem (11) vorzugsweise als geschlossenes System ausgebildet ist. Weiterhin ist eine Vorrichtung (14) zum Beladen und/oder Entladen des Lagersystems (11) mit den Gegenständen (20) vorgesehen, die beispielsweise als Roboter ausgebildet ist. Schließlich ist eine Einrichtung (18) zur Aufnahme von aus dem Lagersystem (11) ausgewählten Gegenständen (20) vorgesehen. Die Vorrichtung (14) zum Beladen und/oder Entladen sowie die Einrichtung (18) zur Aufnahme der ausgewählten Gegenstände (20) sind vorzugsweise innerhalb des als geschlossenes System ausgebildeten Lagersystems (11) angeordnet. Durch die erfindungsgemäße Vorrichtung (10) werden einzelne Gegenstände im Lagersystem (11) gelagert und im freien Zugriff gehalten. Dadurch können einzelne dieser Gegenstände (20) zu neuen logischen Einheiten zusammengestellt werden.

## Beschreibung

Die vorliegende Erfindung betrifft eine Vorrichtung zum Lagern und Kommissionieren von Gegenständen, insbesondere von scheibenartigen Gegenständen wie Wafern oder dergleichen. Weiterhin betrifft die Erfindung eine besondere Verwendung der genannten Vorrichtung.

Bei der Herstellung und Bearbeitung von Wafern (Siliziumscheiben oder dergleichen) in der Halbleiterindustrie ist es üblich und notwendig, daß die Wafer gelagert werden müssen. Bisher sind konventionelle Lagersysteme für Wafer (sogenannte Stocker) ausschließlich zur Lagerung von Behältern ausgelegt. Diese Behälter, die beispielsweise als Kassetten, Boxen, Pods, Foup's oder dergleichen ausgebildet sein können, enthalten jeweils ein Los mit einer Losgröße von beispielsweise 13 oder 25 oder 50 Wafern. Diese Art der Lagerung weist jedoch eine Reihe von Nachteilen auf. So ist beispielsweise eine Kommissionierung einzelner Wafer aus verschiedenen Behältern nur mit großem Aufwand möglich. Als Kommissionierung wird im Rahmen der vorliegenden Erfindung das Zusammenstellen einzelner Wafer zu einer neuen logischen Einheit verstanden.

Um einzelne Wafer aus verschiedenen Behältern in einen neuen Behälter hineinzukommissionieren, ist es bisher notwendig, daß die verschiedenen Behälter, in denen sich die jeweiligen Wafer befinden, zunächst aus dem Lagersystem ausgelagert werden müssen. Sofern es sich bei den Behältern um offene Kassetten oder dergleichen handelt, müssen die gewünschten Wafer anschließend manuell aus den verschiedenen Behältern entnommen werden. Werden jedoch geschlossene Behälter verwendet, ist eine separate Vorrichtung zum Entnehmen der Wafer aus dem Behälter erforderlich. Nach erfolgter Entnahme der jeweiligen Wafer aus den entsprechenden Behältern müssen die ausgewählten Wafer in einem Zielbehälter zusammengeführt werden, was entweder manuell oder automatisch geschieht.

Diese Vorgehensweise ist jedoch relativ zeit- und kostenintensiv. Weiterhin kann es durch die vielen notwendigen Arbeitsschritte zu einer Kontaminierung (Verschmutzung oder dergleichen) der Wafer und damit nicht zuletzt auch zu deren Beschädigung oder Zerstörung kommen.

Ausgehend vom genannten Stand der Technik liegt der vorliegenden Erfindung die Aufgabe zugrunde, eine Vorrichtung zum Lagern und Kommissionieren von Gegenständen zu schaffen, mit der die beschriebenen Nachteile vermieden werden können.

Diese Aufgabe wird erfindungsgemäß durch eine Vorrichtung zum Lagern und Kommissionieren von Gegenständen, insbesondere von scheibenartigen Gegenständen wie Wafern oder dergleichen, gelöst, die erfindungsgemäß ein Lagersystem zur Aufnahme einer Anzahl von Gegenständen, eine Vorrichtung zum Beladen und/oder Entladen des Lagersystems mit den Gegenständen und eine Einrichtung zur Aufnahme von aus dem Lagersystem ausgewählten Gegenständen ausweist.

Durch die erfindungsgemäße Vorrichtung wird es möglich, einzelne Gegenstände, die in dem Lagersystem gelagert sind, zu einer neuen logischen Einheit zusammenzustellen (Kommissionierung).

Durch die Lagerung der Gegenstände, an Stelle von Behältern, in der Vorrichtung, übernimmt die Vorrichtung neben ihrer Lagerfunkion auch die gewünschte Kommissionierfunktion. Lagerung und Kommissionierung erfolgen somit in einer einzigen Vorrichtung.

Wenn in der Vorrichtung beispielsweise Wafer gelagert werden, kann der Bestand an Wafern, die einer Kommissionierung bevorzugt unterliegen (beispielsweise Testwafer, Recycling-Wafer und dergleichen) in dem Lagersystem zentral zusammengefaßt werden. Dadurch kann die Anzahl einzelner Wafertypen, etwa von Testwafern, die beispielsweise bisher in jedem der Behälter in einer bestimmten Anzahl erfoderlich waren, deutlich reduziert werden.

Durch die erfindungsgemäße Vorrichtung wird das Problem gelöst, wie Lose mit verschiedenen Gegenständen mit minimalem zeitlichem und konstruktivem Aufwand zusammengestellt werden können. Dabei liegt der vorliegenden Erfindung die Idee zugrunde, daß einzelne Gegenstände an Stelle von Behältern gelagert und in freiem Zugriff gehalten werden.

Bevorzugte Ausführungsformen der erfindungsgemäßen Vorrichtung ergeben sich aus den Unteransprüchen.

Erfindungsgemäß kann das Lagersystem zur Lagerung der Gegenstände eine Vielzahl von Fächern aufweisen. Die Ausgestaltung der einzelnen Fächer kann je nach Bedarf und Anwendungsfall bzw. der Art der zu lagernden Gegenstände frei gewählt werden. So ist es beispielsweise möglich, daß die Fächer in Form von zumindest teilweise geschlossenen Schubfächern ausgebildet sind. In anderer Ausgestaltung können die Fächer beispielsweise als Schienen- oder Rahmenkonstruktion ausgebildet sein, in der insbesondere scheibenartige Gegenstände wie Wafer oder dergleichen gelagert werden können. Die Erfindung ist nicht auf eine besondere Ausführungsform von Fächern beschränkt.

Vorteilhaft kann das Lagersystem als geschlossenes System ausgebildet sein. Ein geschlossenes System, etwa in Form eines großräumigen Lagerbehälters, hat den Vorteil, daß die darin gelagerten Gegenstände vor einer Kontamination geschützt werden. Dies ist insbesondere für die Lagerung von Wafern in der Halbleiterindustrie zweckmäßig und vorteilhaft.

Wenn sich die Vorrichtung zum Lagern und Kommissionieren von Gegenständen beispielsweise in einem Reinraum oder dergleichen befindet, wo eine Kontaminierung der gelagerten Gegenstände ausgeschlossen ist, kann das Lagersystem auch als offenes System, beispielsweise als offen zugängliches Regal oder dergleichen ausgebildet sein.

Vorteilhaft ist die Vorrichtung zum Beladen und/oder Entladen des Lagersystems als Roboter, vorzugsweise als Roboterarm ausgebildet. Ein solcher Roboter hat den Vorteil, daß er in alle Richtungen beweglich ist, so daß das Lagersystem in dichtest möglicher Weise mit zu lagernden Gegenständen bestückt werden kann. Eine besondere Ausgestaltungsform des Roboters ist nicht erforderlich.

In weiterer Ausgestaltung kann die Einrichtung zur Aufnahme von aus dem Lagersystem ausgewählten Gegenständen als Behälter ausgebildet sein. Beispiele für derartige Behälter sind unter anderem Boxen, Kassetten oder dergleichen, die je nach Bedarf und Anwendungsfall offen oder verschließbar ausgebildet sein können. Natürlich ist es auch denkbar, daß die Einrichtung zur Aufnahme der Gegenstände eine andere Form aufweist.

Vorteilhaft ist die Vorrichtung zum Beladen und/oder Entladen des Lagersystems und/oder die Einrichtung von aus dem Lagersystem ausgewählten Gegenständen innerhalb des als geschlossenes System ausgebildeten Lagersystems angeordnet. Dadurch wird verhindert, daß die Gegenstände während des Kommissionierens verschmutzt oder beschädigt werden können.

In weiterer Ausgestaltung kann das Lagersystem wenigstens eine Abgabe-/Aufnahmeöffnung aufweisen. Die Abgabe-/Aufnahmeöffnung ist insbesondere dann von Vorteil, wenn das Lagersystem als geschlossenes System ausgebildet ist. Über die Abgabe-/Aufnahmeöffnung können die Gegenstände, die über die Belade-/Entlade-Vorrichtung in der Einrichtung zur Aufnahme der ausgewählten Gegenstände abgelegt wurden, aus dem Lagersystem nach außen abtransportiert werden.

Vorteilhaft ist die Abgabe-/Aufnahmeöffnung verschließbar ausgebildet. Dies kann beispielsweise über eine verschwenkbare Klappe, eine Tür oder dergleichen erfolgen. Insbesondere dann, wenn eine Kontaminierung der im Lagersystem befindlichen Gegenstände verhindert werden soll, ist die Abgabe-/Aufnahmeöffnung vorzugsweise über eine geeignete Schleuse verschließbar bzw. verschlossen.

Die vorstehend beschriebene erfindungsgemäße Vorrichtung zum Lagern und Kommissionieren von Gegenständen wird besonders bevorzugt zum Lagern und Kommissionieren von Wafern verwendet. Insbesondere können die Wafer einen Scheibendurchmesser von bis zu 300 mm aufweisen.

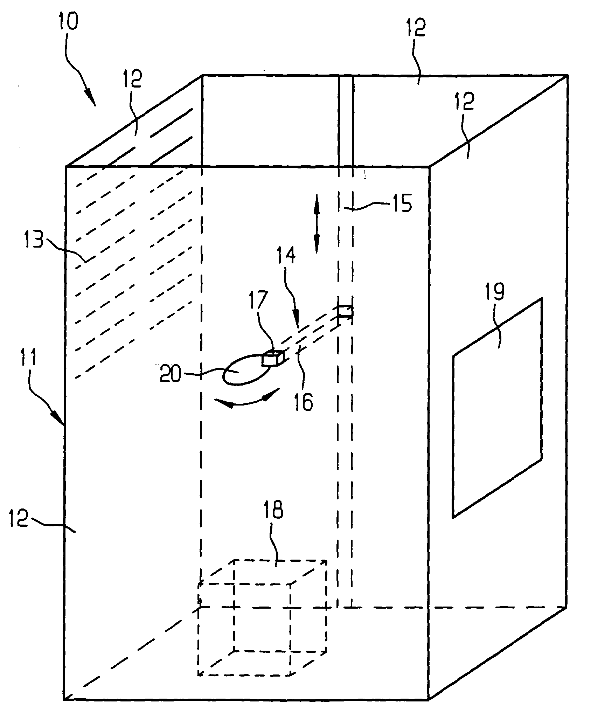

Die Erfindung wird nun an Hand eines Ausführungsbeispiels unter Bezugnahme auf die beiliegende Zeichnung näher erläutert. Dabei stellt die einzige Figur 1 in schematischer Ansicht eine erfindungsgemäße Vorrichtung zum Lagern und Kommissionieren von Gegenständen dar.

Die in der Figur 1 dargestellte Vorrichtung 10 dient zum Lagern und Kommissionieren von Wafern 20 für die Halbleiterindustrie. Die Vorrichtung 10 weist ein als geschlossenes System ausgebildetes Lagersystem 11 auf. Das Lagersystem 11 hat einen rechteckigen Grundquerschnitt. Es weist jeweils vier Seitenwände 12 auf, an denen eine Vielzahl von Fächern 13 für die Aufnahme von Wafern 20 vorgesehen sind. Der besseren Übersicht halber sind in gestrichelter Weise nur einige der Fächer 13 an einer der Seitenwände 12 angedeutet. Die einzelnen Fächer 13 befinden sich jedoch an jeder der vier Seitenwände 12, und zwar über deren gesamte Querschnittsfläche verteilt. In jedem der Fächer 13 ist ein Wafer 20 gelagert. Über ein nicht dargestelltes Boden- und Deckelelement ist das Lagersystem 11 von der Außenumgebung abgeschlossen, so daß die im Lagersystem 11 befindlichen Wafer 20 durch äußere Einflüsse weder verschmutzt noch beschädigt werden können.

Innerhalb des Lagersystems 11 ist weiterhin eine Vorrichtung 14 zum Beladen und/oder Entladen des Lagersystems 11 vorgesehen, die im vorliegenden Fall als Roboter ausgebildet ist. Der Roboter 14 besteht aus einem Roboterarm 16, der über eine Führungsschiene 15, die an einer der Seitenwände 12 angeordnet ist, in Höhenrichtung verfahrbar ist. Um eine optimale Gelenkigkeit des Roboterarms 16 zu erzielen, kann der Roboterarm 16 weiterhin wenigstens ein Gelenk aufweisen und teleskopartig verschiebbar ausgebildet sein. Weiterhin weist der Roboterarm 16 ein Greifelement 17 auf, mit dem die Wafer 20 gegriffen bzw. gehalten werden können. An Stelle des in Figur 1 beschriebenen Roboters 14 kann natürlich auch ein im Lagersystem 11 freistehend angeordneter Roboterarm vorgesehen sein. Die Erfindung ist nicht auf eine besondere Ausgestaltungsform der Vorrichtung zum Beladen und/oder Entladen des Lagersystems 11 beschränkt.

Um die im Lagersystem 11 gelagerten Wafer 20 zu einer neuen logischen Einheit kommissionieren zu können, ist weiterhin eine Einrichtung 18 zur Aufnahme von aus dem Lagersystem 11 ausgewählten Wafern 20 vorgesehen. Die Einrichtung 18 befindet sich ebenfalls wie die Vorrichtung 14 innerhalb des als geschlossenes System ausgebildeten Lagersystems 11. Die Einrichtung 18, die beispielsweise als Box, Kassette oder dergleichen ausgebildet sein kann, dient zur Aufnahme derjenigen Wafer 20, die über den Roboter 14 aus den Fächern 13 des Lagersystems 11 entnommen und zu der neuen logischen Einheit zusammengestellt werden sollen.

Die Einrichtung 18 kann über eine Abgabe-/Aufnahmeöffnung 19 aus dem Lagersystem 11 nach außen abgegeben werden. Um eine Kontaminierung des von den Seitenwänden 12 des Lagersystems 11 gebildeten abgeschlossenen Innenraums zu verhindern, ist die Abgabe-/Aufnahmeöffnung 19 über eine nicht dargestellte Schleuseneinrichtung verschließbar ausgebildet.

In der erfindungsgemäßen Vorrichtung 10 müssen nun nicht mehr, wie dies bei den im Stand der Technik bekannten Lösungen erforderlich war, einzelne Behälter gelagert werden, in denen wiederum die einzelnen Wafer 20 gelagert sind. Statt dessen werden die Wafer 20 direkt im Lagersystem 11 gelagert. Damit kann die Vorrichtung 10 neben der Lagerfunktion gleichzeitig auch die gewünschte Kommissionierfunktion übernehmen. Lagerung und Kommissionierung erfolgen mit ein und derselben Vorrichtung 10. Damit können individuelle Lose an verschiedenen Wafern 20 mit minimalem Aufwand individuell zusammengestellt werden. Dazu werden die in den einzelnen Fächern 13 des Lagersystems 11 befindlichen Wafer 20 über das Greifelement 17 des Roboterarms 16 aus den Fächern 13 entnommen und in der Einrichtung 18 zur Aufnahme der Wafer 20 abgelegt. Die entsprechend bestückte Einrichtung 18 kann anschließend über die Abgabe-/Aufnahmeöffnung 19 nach außen abgegeben werden. Dies kann beispielsweise mit Hilfe des Roboters 14 erfolgen. Natürlich ist es auch denkbar, daß die Einrichtung 18 außerhalb des Lagersystems 11 vorgesehen ist. In diesem Fall werden einzelne der im Lagersystem 11 gelagerten Wafer 20 über den Roboterarm 16 und die Abgabe-/Aufnahmeöffnung 19 aus dem Lagersystem 11 hinaus und in die dort befindliche Einrichtung 18 zur Aufnahme der Wafer 20 befördert.

## Patentansprüche

1. Vorrichtung zum Lagern und Kommissionieren von Gegenständen, insbesondere von scheibenartigen Gegenständen wie Wafern oder dergleichen, mit einem Lagersystem (11) zur Aufnahme einer Anzahl von Gegenständen (20), einer Vorrichtung (14) zum Beladen und/oder Entladen des Lagersystems (11) mit den Gegenständen (20) und einer Einrichtung (18) zur Aufnahme von aus dem Lagersystem (11) ausgewählten Gegenständen (20).

2. Vorrichtung nach Anspruch 1, **dadurch**
**gekennzeichnet**, daß das Lagersystem (11) zur Lagerung der Gegenstände (20) eine Vielzahl von Fächern (13) aufweist.

3. Vorrichtung nach Anspruch 1 oder 2, **dadurch**
**gekennzeichnet**, daß das Lagersystem (11) als geschlossenes System ausgebildet ist.

4. Vorrichtung nach einem der Ansprüche 1 bis 3,
**dadurch gekennzeichnet**, daß die Vorrichtung (14) zum Beladen und/oder Entladen des Lagersystems (11) als Roboter, vorzugsweise als Roboterarm (16), ausgebildet ist.

5. Vorrichtung nach einem der Ansprüche 1 bis 4,
**dadurch gekennzeichnet**, daß die Einrichtung (18) zur Aufnahme von aus dem Lagersystem (11) ausgewählten Gegenständen (20) als Behälter ausgebildet ist.

6. Vorrichtung nach einem der Ansprüche 3 bis 5,
**dadurch gekennzeichnet**, daß die Vorrichtung (14) zum Beladen und/oder Entladen des Lagersystems (11) und/oder die Einrichtung (18) zur Aufnahme von aus dem Lagersystem (11) ausgewählten Gegenständen (20) innerhalb des als geschlossenes System ausgebildeten Lagersystems (11) angeordnet ist/sind.

7. Vorrichtung nach einem der Ansprüche 3 bis 6,
**dadurch gekennzeichnet**, daß das Lagersystem (11) wenigstens eine Abgabe-/Aufnahmeöffnung (19) aufweist.

8. Vorrichtung nach Anspruch 7, **dadurch**
**gekennzeichnet**, daß die Abgabe-/Aufnahmeöffnung (19) verschließbar ausgebildet ist.

9. Verwendung einer Vorrichtung nach einem der Ansprüche 1 bis 8 zum Lagern und Kommissionieren von Wafern, insbesondere von Wafern mit einem Scheibendurchmesser bis 300 mm.
